# EUROPEAN PATENT APPLICATION

(11) **EP 4 648 113 A1**
(43) Date of publication of application: **12.11.2025**
(21) Application number: 23914539.4
(22) Date of filing: 25.12.2023
(51) Int. Cl.: H01L 31/18, H01L 31/068

(54) **INTERDIGITAL BACK-CONTACT SOLAR CELL AND MANUFACTURING METHOD THEREFOR**

(30) Priority: 06.01.2023 CN 202310017915
(71) Applicant: CHINT New Energy Technology Co., Ltd., Jiaxing, Zhejiang 314415 (CN)
(72) Inventor: LI, Hongbo, Haining City, Jiaxing, Zhejiang 314415 (CN); HE, Sheng, Jiaxing, Zhejiang 314415 (CN); ZHANG, Jia, Jiaxing, Zhejiang 314415 (CN)
(74) Representative: PGA S.p.A., Milano, Succursale di Lugano
(86) International application number: PCT/CN2023/141689
(87) International publication number: WO 2024/146407

(57) **Abstract**

The present application relates to the field of photovoltaic manufacturing, and in particular to an interdigitated back-contact solar cell and a manufacturing method therefor. The manufacturing method for an interdigitated back-contact solar cell comprises: sequentially arranging a tunneling layer and an N-type polysilicon layer on a backlight face of P-type substrate silicon, so as to obtain a basic silicon wafer; performing etching on a preset partition region of a backlight face of the basic silicon wafer, so as to obtain a patterned isolation groove, wherein the isolation groove separates a P-type interdigitated region from an N-type interdigitated region; performing phosphorus doping on a side wall and the bottom face of the isolation groove; removing the N-type polysilicon layer and the tunneling layer which have been subjected to phosphorus doping and are located in the P-type interdigitated region, so as to obtain a photovoltaic precursor, and performing lamination passivation on a surface of the photovoltaic precursor, and performing metallization, so as to obtain an interdigitated back-contact solar cell. In the present disclosure, the isolation groove is doped with phosphorus atoms, such that the conductivity of the side wall and the bottom face of the isolation groove is greatly weakened, thereby improving the photoelectric conversion efficiency of the cell.

## Description

This application claims the priority to Chinese Patent Application No. 2023100179152, titled "INTERDIGITAL BACK-CONTACT SOLAR CELL AND MANUFACTURING METHOD THEREFOR", filed on January 6, 2023 with the China National Intellectual Property Administration, which is incorporated herein by reference in its entirety.

### FIELD

The present disclosure relates to the technical field of photovoltaic manufacturing, and in particular to an interdigitated back contact solar cell and a method for manufacturing the interdigitated back contact solar cell.

### BACKGROUND

With the advancement of photovoltaic technology, interdigitated solar cells have emerged as a cutting-edge research focus in photovoltaic power generation. Light-receiving surfaces of the interdigitated back contact solar cells are free of grid lines, eliminating shading loss of approximately 5% caused by conventional front grid lines while reducing a back-surface recombination rate of photogenerated carriers, and having a higher fill factor.

Specifically, for interdigitated solar cells, isolation grooves on back surfaces are adopted to isolate P-type interdigitated regions from N-type interdigitated regions. However, in related art, increasing physical distances merely through grooves or barriers results in poor isolation performance. Many carriers drift directly from the P-type interdigitated regions to the N-type interdigitated regions across isolation regions without passing through external circuits, leading to increased internal losses and reduced output power in solar cells.

Therefore, how to improve the performance of isolation between interdigitated regions of interdigitated back contact solar cells and improve cell photoelectric conversion efficiency is an issue to be urgently resolved by those skilled in the art.

### SUMMARY

The present disclosure aims to provide an interdigitated back contact solar cell and a method for manufacturing the interdigitated back contact solar cell, to solve the issue of poor isolation performance of an interdigitated back contact solar cell in related art.

To solve the above issue, a method for manufacturing an interdigitated back contact solar cell is provided in the present disclosure. The method includes:
sequentially arranging a tunneling layer and an N-type polysilicon layer on a back surface of a P-type silicon substrate to obtain a base silicon wafer;
etching a predetermined isolation region on a back surface of the base silicon wafer to obtain an isolation groove which is patterned, where the isolation groove isolates a P-type interdigitated region from an N-type interdigitated region;
performing phosphorus doping on a sidewall and a bottom surface of the isolation groove;
removing the N-type polysilicon layer and the tunneling layer which are phosphorus-doped and arranged within the P-type interdigitated region to obtain a photovoltaic precursor; and
performing stacked passivation and metallization on a surface of the photovoltaic precursor to obtain an interdigitated back contact solar cell.

In an embodiment, the sequentially arranging a tunneling layer and an N-type polysilicon layer on a back surface of a P-type silicon substrate to obtain a base silicon wafer includes:
arranging a tunneling layer on the back surface of the P-type silicon substrate;
arranging an intrinsic amorphous silicon layer on a surface of the tunneling layer; and
performing phosphorus diffusion on the P-type silicon substrate arranged with the intrinsic amorphous silicon layer, such that the intrinsic amorphous silicon layer is converted into an N-type polysilicon layer to obtain the base silicon wafer, and generating, on a surface of the base silicon wafer, a PSG layer to be removed.

In an embodiment, the performing phosphorus diffusion on the P-type silicon substrate arranged with the intrinsic amorphous silicon layer includes:
performing double-sided phosphorus diffusion on the P-type silicon substrate arranged with the intrinsic amorphous silicon layer to generate, on both surfaces of the base silicon wafer, the PSG layer to be removed.

In an embodiment, before the performing phosphorus doping on a sidewall and a bottom surface of the isolation groove, the method further includes:
performing alkali polishing on the isolation groove.

In an embodiment, the performing phosphorus doping on a sidewall and a bottom surface of the isolation groove includes:
performing phosphorus ion implantation on a surface of the base silicon wafer and removing the PSG layer; and
annealing the base silicon wafer for which the PSG layer is removed, to complete phosphorus doping, and forming, on the surface of the base silicon wafer, a thermal silicon oxide layer to be removed.

In an embodiment, before the removing the N-type polysilicon layer and the tunneling layer which are phosphorus-doped and arranged within a P-type interdigitated region to obtain a photovoltaic precursor, the method further includes:
performing a first texturing on a light-receiving surface of the base silicon wafer. Both the light-receiving surface and the back surface of the base silicon wafer are in contact with a solution for the first texturing.

In an embodiment, the removing the N-type polysilicon layer and the tunneling layer which are phosphorus-doped and arranged within a P-type interdigitated region to obtain a photovoltaic precursor includes:
performing acid etching on the P-type interdigitated region to remove a thermal silicon oxide layer in the P-type interdigitated region; and
removing the N-type polysilicon layer in the P-type interdigitated region, and performing wet cleaning to remove the thermal silicon oxide layer and the tunneling layer on the back surface of the base silicon wafer, to obtain the photovoltaic precursor.

In an embodiment, the removing the N-type polysilicon layer in the P-type interdigitated region includes:
performing a second texturing on a light-receiving surface of the base silicon wafer and removing the N-type polysilicon layer in the P-type interdigitated region through a solution for the second texturing.

In an embodiment, before the sequentially arranging a tunneling layer and an N-type polysilicon layer on a back surface of a P-type silicon substrate, the method further includes:
performing double-sided polishing on the P-type silicon substrate.

An interdigitated back contact solar cell is provided in the present disclosure. The interdigitated back contact solar cell includes a P-type silicon substrate. A back surface of the P-type silicon substrate includes: a P-type interdigitated region, an N-type interdigitated region, and an isolation groove.

The isolation groove is configured to isolate the P-type interdigitated region from the N-type interdigitated region;
The N-type interdigitated region includes a tunneling layer and an N-type polysilicon layer from inside to outside;
A sidewall and a bottom surface of the isolation groove are arranged with a phosphorus-doped neutral layer;
An outermost side of a light-receiving surface and an outermost side of the back surface of the P-type silicon substrate include a passivation layer;
An N-type electrode of the interdigitated back contact solar cell is arranged in the N-type interdigitated region, where the N-type electrode is configured to penetrate through the passivation layer to contact with the N-type polysilicon layer; and
A P-type electrode of the interdigitated back contact solar cell is arranged in the P-type interdigitated region. The P-type electrode is configured to penetrate through the passivation layer to contact with the P-type silicon substrate.

The method for manufacturing an interdigitated back contact solar cell according to the present disclosure includes: sequentially arranging a tunneling layer and an N-type polysilicon layer on a back surface of a P-type silicon substrate to obtain a base silicon wafer; etching a predetermined isolation region on a back surface of the base silicon wafer to obtain a isolation groove which is patterned, where the isolation groove isolates a P-type interdigitated region from an N-type interdigitated region; performing phosphorus doping on a sidewall and a bottom surface of the isolation groove; removing the N-type polysilicon layer and the tunneling layer which are phosphorus-doped and arranged within a P-type interdigitated region to obtain a photovoltaic precursor; and performing stacked passivation and metallization on a surface of the photovoltaic precursor to obtain an interdigitated back contact solar cell.

According to the present disclosure, phosphorus atoms with a polarity opposite to that of the P-type silicon substrate are doped in an isolation groove between a P-type emitter (that is, a P-type interdigitated emitter) and an N-type emitter (that is, an N-type interdigitated emitter). Counter-doping with the concentration may increase the sheet resistance of the region, potentially becoming intrinsic silicon. Thus, the conductivity of the sidewalls and bottom surface of the isolation groove is greatly reduced, significantly reducing the carrier concentration in the region. In this way, electrical isolation between interdigitated regions is enhanced, thereby reducing the internal loss of a battery and improving the photoelectric conversion efficiency of the battery. An interdigitated back contact solar cell provided with the above beneficial effects is also provided in the present disclosure.

### BRIEF DESCRIPTION OF THE DRAWINGS

To more clearly describe the technical solutions in the embodiments of the present disclosure or the technical solutions in related art, drawings to be used in the description of the embodiments of the present disclosure or the related art are briefly described hereinafter. It is apparent that the drawings described below are merely used for illustrating the embodiments of the present disclosure, and those skilled in the art can obtain other drawings according to the provided drawings without any creative effort.
FIG. 1 is a flowchart of a method for manufacturing an interdigitated back contact solar cell according to embodiment 1 of the present disclosure;
FIG. 2 is a flowchart of a method for manufacturing an interdigitated back contact solar cell according to embodiment 2 of the present disclosure; and
FIG. 3 is a structural schematic diagram of an interdigitated back contact solar cell according to an embodiment of the present disclosure.

### DETAILED DESCRIPTION

To enable those skilled in the art to understand the solutions of the present disclosure, the technical solutions of the embodiments of the present disclosure are described in detail below in conjunction with the drawings of the embodiments of the present disclosure. Apparently, the embodiments described below are only some of the embodiments of the present disclosure, rather than all of the embodiments of the present disclosure. Any other embodiments obtained by those skilled in the art based on the embodiments in the present disclosure without creative efforts shall fall within the protection scope of the present disclosure.

### Embodiment 1

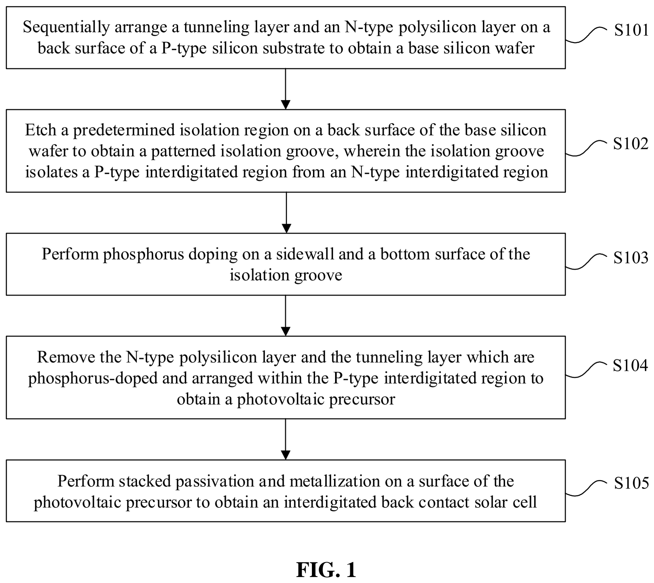

The core of the present disclosure is to provide a method for manufacturing an interdigitated back contact solar cell. A flowchart of the method for manufacturing the interdigitated back contact solar cell according to an embodiment is shown in FIG. 1 as, which is referred to as embodiment 1. The method includes the following steps.

In step S101, a tunneling layer and an N-type polysilicon layer are sequentially arranged on a back surface of a P-type silicon substrate to obtain a base silicon wafer.

In an embodiment, step S101 includes the following operations A1 to A3.

In operation A1, a tunneling layer is arranged on the back surface of the P-type silicon substrate.

In an embodiment, the tunneling layer deposited on the back surface may adopt silicon oxide, oxynitride or nitride. The method for arranging the tunneling layer includes any one of LPCVD (Low-Pressure Chemical Vapor Deposition), PECVD (Plasma-Enhanced Chemical Vapor Deposition), and PEALD (Plasma-Enhanced Atomic Layer Deposition), and a thickness of the tunneling layer may be between 0.1 nm and 5 nm.

In operation A2, an intrinsic amorphous silicon layer is arranged on a surface of the tunneling layer.

In an embodiment, the method for arranging the intrinsic amorphous silicon layer includes at least one of LPCVD, PEALD, and PVD (physical deposition). A thickness of the intrinsic amorphous silicon layer may be between 30 nm and 300 nm.

In operation A3, phosphorus diffusion is performed on the P-type silicon substrate arranged with the intrinsic amorphous silicon layer. The intrinsic amorphous silicon layer is converted into an N-type polysilicon layer to obtain the base silicon wafer, and a PSG (Phosphosilicate Glass) layer to be removed is generated on a surface of the base silicon wafer.

In an embodiment, surface phosphorus diffusion may be performed on a silicon wafer through high-temperature tubular phosphorus diffusion with POCL₃ as a phosphorus source or phosphorus ion implantation followed by oxidation annealing. A target sheet resistance ranges from 20 Ω/m to 80 Ω/m. In a process of phosphorus diffusion on the P-type silicon substrate, a phosphorus-containing silicon oxide layer, commonly known as a PSG layer, is formed on a surface of the base silicon wafer. A thickness of the PSG layer ranges from 40 nm to 60 nm. The formed PSG layer may serve as a protective layer in subsequent production processes to prevent corrosion of other underlying epitaxial layer.

In an embodiment, in operation A3, the method for performing phosphorus diffusion on the P-type silicon substrate arranged with the intrinsic amorphous silicon layer includes:
performing double-sided phosphorus diffusion on the P-type silicon substrate arranged with the intrinsic amorphous silicon layer to generate the PSG layer to be removed on both sides of the base silicon wafer.

In an embodiment, with the double-sided phosphorus diffusion in the solution, a conventional phosphorus-doped emitter (that is, the PSG layer described above) is formed on the light-receiving surface to absorb impurities. In a subsequent texturing, the emitter is removed together with the absorbed impurities. Before the removal, the PSG layer on the light-receiving surface serves as a protective layer to prevent the light-receiving surface of the P-type silicon substrate from being damaged.

In step S102, a predetermined isolation region on a back surface of the base silicon wafer is etched to obtain a patterned isolation groove. The isolation groove isolates a P-type interdigitated region from an N-type interdigitated region.

In the above embodiment, after the double-sided phosphorus diffusion, PSG layers, that is, phosphorus-doped silicon dioxide layers, are formed on the front and back surfaces of the base silicon wafer. An acid etching material (width range from 50 µm to 100 µm) is screen-printed according to the pattern of an isolation region. The etching material may etch and remove an epitaxial layer in the isolation region, exposing the underlying P-type silicon substrate.

In an implementation, the acid etching material includes oxalic acid, surfactant, thickener, modified silicon dioxide, deionized water, and sodium fluoride and etches away the PSG layers at room temperature or with heating. The composition contents are as follows: oxalic acid 5wt%-20wt%, surfactant 5wt%-10wt%, thickener 10wt%-20wt%, modified silicon dioxide 20wt%-40wt%, deionized water 5wt%-20wt%, and sodium fluoride 1wt%-10wt%. Residual etching materials are cleaned and removed after the printing of the etching material. The PSG layer which is not printed with acid etching material on the back surface still remains and serves as an alkali barrier layer in a subsequent polishing process to protect underlying N-type doped polysilicon. In the implementation, the PSG layer serves as an auxiliary product in the phosphorus diffusion process to block alkali etching, eliminating the need for separately depositing a silicon oxide layer or a silicon nitride layer as a barrier layer for alkali etching, thereby reducing process steps and cost.

In step S103, phosphorus doping is performed on a sidewall and a bottom surface of the isolation groove.

This step may include the following operations B1 and B2.

In operation B1, phosphorus ion implantation is performed on a back surface of the base silicon wafer and the PSG layer is removed from it.

Phosphorus ions are implanted on the back surface through an ion implantation process, and an implantation concentration is 0.1 to 1 times of a doping concentration of the silicon substrate. Since an isolation groove is not protected by the PSG layer, phosphorus ions are directly implanted, with a depth of 10 nm to 20 nm, into the bottom surface and sidewalls of the isolation groove. Regions other than the isolation groove are protected by the PSG layer, and the phosphorus ions implanted only exist on the PSG layer on the surface and are not implanted into the N-type polysilicon beneath the PSG layer.

In operation B2, the base silicon wafer for which the PSG layer is removed is annealed to complete phosphorus doping. A thermal silicon oxide layer to be removed is formed on a surface of the base silicon wafer.

In the operation, the PSG layers on the light-receiving surface and the back surface may be cleaned and removed through Hydrofluoric (HF) acid, and oxidation annealing at 850°C is performed to promote and activate phosphorus on the sidewalls of the isolation groove, thereby performing doping. In the oxidation annealing process, a thermal oxide layer having a thickness of 20 nm to 50 nm is formed on the back surface.

In an embodiment, before the step, the method further includes:
performing alkali polishing on the isolation groove.

In an embodiment, the PSG layer in step S102 serves as an alkali barrier layer to protect the N-type doped polysilicon beneath the PSG layer, simplifying the process and improving the production efficiency during surface polishing and modification.

In an embodiment, the base silicon wafer with acid etching materials cleaned off is polished. That is, the polishing process is performed using a solution including 5% to 20% potassium hydroxide, sodium hydroxide, and TMAH (tetramethylammonium hydroxide), with an additive. The additive protects the oxide layer to ensure that the PSG layer is not etched excessively, leaving a residual thickness of the PSG layer of 30 nm to 50 nm. A polished flat structure is formed in a region not covered and protected by the PSG layer. That is, an isolation groove on the back surface has a polished structure and a depth of 5 µm to 10 µm. The light-receiving surface of the base silicon wafer is protected by the PSG layer and is not polished.

In step S104, the N-type polysilicon layer and the tunneling layer which are phosphorus-doped and arranged within the P-type interdigitated region are removed to obtain a photovoltaic precursor.

In an embodiment, the step includes the following operations C1 and C2.

In operation C1, acid etching is performed on the P-type interdigitated region to remove the thermal silicon oxide layer in the P-type interdigitated region.

In the operation, an acid etching material may be screen-printed with a width of 200 µm to 300 µm according to a pattern of the P-type interdigitated region. Theetching material may etch and remove the thermal oxide layer therein, exposing the underlying N-type doped polysilicon layer.

In operation C2, the N-type polysilicon layer in the P-type interdigitated region is removed, and wet cleaning is performed to remove the thermal silicon oxide layer and the tunneling layer on the back surface of the base silicon wafer, to obtain a photovoltaic precursor.

Many methods may be performed to remove the N-type polysilicon layer in the P-type interdigitated region, which are not enumerated herein. In an embodiment, removing the N-type polysilicon layer in the P-type interdigitated region described in operation C2 includes:
performing a second texturing on a light-receiving surface of the base silicon wafer and removing the N-type polysilicon layer in the P-type interdigitated region through a solution for the second texturing.

In the embodiment, a second texturing is directly performed on the base silicon wafer to: remove the N-type polysilicon layer exposed on the back surface of the P-type silicon substrate after being processed through operation C1; and perform a second texturing on the texture of the light-receiving surface to form finer microstructures for enhanced light trapping. To remove only the polysilicon layer exposed on the back surface without damaging the polished surface structure of the P-type silicon substrate, for the second texturing, the N-type polysilicon layer is removed within a short period of time by using a conventional texturing bath formula, and the texturing time is 0.1 to 0.2 times of conventional texturing time. Additionally, a tunneling oxide layer is arranged beneath the N-type polysilicon layer, and the polished surface of the P-type interdigitated region is further protected from texturing.

It should be noted that before the step, the method further includes:
performing a first texturing on a light-receiving surface of the base silicon wafer. Both the light-receiving surface and the back surface of the base silicon wafer are in contact with a solution for the first texturing.

Before the texturing, a byproduct warp-around silicon oxide layer on the light-receiving surface of the silicon wafer may be removed using a chain-type HF. Subsequently, texturing is performed, that is, in a solution containing 5% to 20% potassium hydroxide, sodium hydroxide and TMAH, with a texturing additive as well as an additive for protecting the oxide layer. That is, the entire light-receiving surface is textured to form a pyramidal texture to trap light. The back surface is protected by a thermal oxide layer from texturing. The thermal oxide layer on the back surface is consumed in the first texturing process, leaving a residual thickness of 15 nm to 45 nm for the thermal silicon oxide layer on the back surface after texturing.

In step S105, stacked passivation and metallization are performed on a surface of the photovoltaic precursor to obtain an interdigitated back contact solar cell.

In an embodiment, the method for stacked passivation includes the following.

A hydrogen-including dielectric layer is deposited on both the light-receiving and back surfaces to achieve chemical passivation of the back surface. In an embodiment, the back surface is deposited with a passivation stack of aluminum oxide and silicon nitride. The aluminum oxide is deposited through PECVD, ALD, or PEALD, with a thickness of 2 nm to 20 nm. The silicon nitride is deposited through PECVD, ALD, or PEALD, with a thickness of 60 nm to 200 nm. The light-receiving surface is deposited with a stack of aluminum oxide, silicon nitride, and silicon oxide through PECVD, ALD, or PEALD with thicknesses of 2 nm to 20 nm, 50 nm to 80 nm, or 5 nm to 20 nm, respectively.

In an embodiment, the method for metallization includes the following.

The P-type interdigitated region is partially opened using a laser beam or an acid etching material. A pattern of the opening includes dots, spaced-apart dots, lines, spaced-apart lines, or spaced-apart dots and lines. The diameter or width of the opening is 10 µm to 50 µm. Only the dielectric layer in the opening region is removed, without damaging the structure of the underlying layer. A low-etching silver paste or silver-aluminum paste is printed with a width of 50 µm to 100 µm over the opening region of the P-type interdigitated region, forming electrical contact with P-type silicon. An etching silver paste is printed over the N-type polysilicon. The glass component in the etching silver paste may etch through the dielectric layer so that silver is in contact with the N-type polysilicon. Co-firing is performed at 600° C to 800° C to form an electrode.

In the embodiment, the method for manufacturing an interdigitated back contact solar cell of the present disclosure includes: sequentially arranging a tunneling layer and an N-type polysilicon layer on a back surface of a P-type silicon substrate to obtain a base silicon wafer; etching a predetermined isolation region on a back surface of the base silicon wafer to obtain a patterned isolation groove, where the patterned isolation groove isolates a P-type interdigitated region from an N-type interdigitated region; performing phosphorus doping on a sidewall and a bottom surface of the patterned isolation groove; removing the N-type polysilicon layer and the tunneling layer which are phosphorus-doped and arranged within a P-type interdigitated region to obtain a photovoltaic precursor; and performing stacked passivation and metallization on a surface of the photovoltaic precursor to obtain an interdigitated back contact solar cell.

According to the present disclosure, phosphorus atoms with a polarity opposite to that of the P-type silicon substrate are doped in the isolation groove between a P-type emitter (that is, a P-type interdigitated emitter) and an N-type emitter (that is, an N-type interdigitated emitter). Counter-doping with the concentration may increase the sheet resistance of the isolation groove, potentially generating intrinsic silicon. Thus, the conductivity of the sidewalls and bottom surface of the isolation groove is greatly reduced, significantly reducing the carrier concentration in the isolation groove. In this way, electrical isolation between interdigitated regions is enhanced, thereby reducing the internal loss of a battery and improving the photoelectric conversion efficiency of the battery.

### Embodiment 2

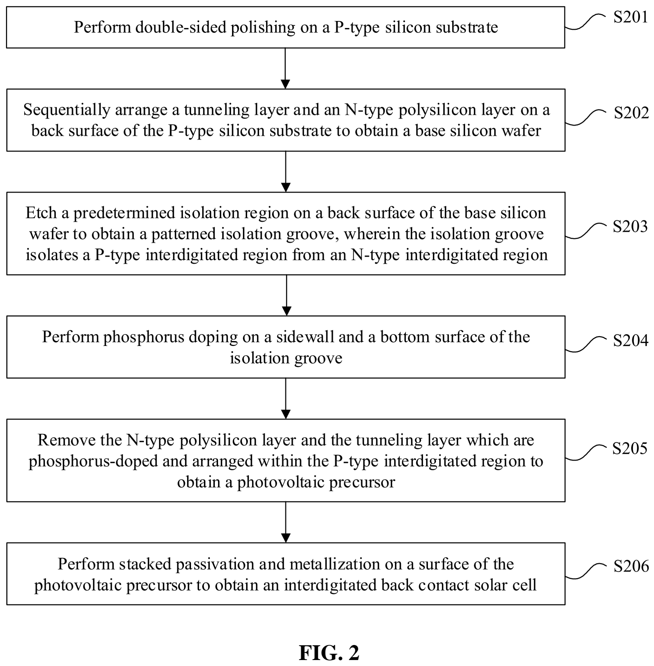

On basis of embodiment 1, the P-type silicon substrate is pre-processed according to the embodiment 2. FIG. 2 shows the flowchart according to embodiment 2. As shown in FIG. 2, the method for manufacturing an interdigitated back contact solar cell includes the following steps.

In step S201, double-sided polishing is performed on a P-type silicon substrate.

In step S202, a tunneling layer and an N-type polysilicon layer are sequentially arranged on a back surface of the P-type silicon substrate to obtain a base silicon wafer.

In step S203, a predetermined isolation region on a back surface of the base silicon wafer is etched to obtain a patterned isolation groove. The patterned isolation groove isolates a P-type interdigitated region from an N-type interdigitated region.

In step S204, phosphorus doping is performed on a sidewall and a bottom surface of the isolation groove.

In step S205, the N-type polysilicon layer and the tunneling layer which are phosphorus-doped and arranged within the P-type interdigitated region are removed to obtain a photovoltaic precursor.

In step S206, stacked passivation and metallization are performed on a surface of the photovoltaic precursor to obtain an interdigitated back contact solar cell.

The difference between the present embodiment and embodiment 1 is that the P-type silicon substrate is polished in advance in the embodiment. Other steps in embodiment 2 are the same as the steps in embodiment 1 and are not repeated herein.

In the embodiment, the double-sided polishing on the P-type silicon substrate may be implemented as alkali polishing. In an implementation, a solution including 5% to 20% potassium hydroxide, sodium hydroxide, TMAH and the like is applied for the polishing. In addition, a polishing additive is added to smooth a surface. A chemical reaction is performed within a temperature range of 60°C to 90°C to remove a cutting damage on the surface of the silicon substrate, smooth the surface, and reduce surface defects. In this way, the growth quality of an epitaxial layer is improved, thereby reducing the internal resistance of a battery and further improve the photoelectric conversion efficiency of the battery.

The following describes a complete process for manufacturing an interdigitated back contact solar cell in an actual production situation for reference. The process includes the following steps 1 to 12.

In step 1, double-sided polishing is performed on a P-type silicon wafer.

In an embodiment, both surfaces of the P-type silicon wafer are polished through conventional alkali polishing. An alkali polishing solution includes 5% to 20% potassium hydroxide, sodium hydroxide, TMAH and the like. A polishing additive is added to smooth a surface. A chemical reaction is performed within a temperature range of 60°C to 90°C, to remove a cutting damage on the surface, smooth the surface, and reduce surface defects.

In step 2, a tunneling layer and an intrinsic amorphous silicon layer are deposited on a back surface of the P-type silicon wafer.

In an embodiment, a tunneling layer is deposited on the back surface. The tunneling layer is deposited using a silicon oxide, oxynitride or nitride method. The nitride method includes low pressure chemical vapor deposition (LPCVD), plasma enhanced chemical vapor deposition (PECVD), and plasma enhanced atomic layer deposition (PEALD). A thickness of the tunneling layer is between 0.1 nm and 5 nm. Then, the intrinsic amorphous silicon layer is deposited. The deposition method includes LPCVD, PEALD and PVD (physical deposition). A thickness of the intrinsic amorphous silicon layer is between 30 nm and 300 nm.

In step 3, double-sided phosphorus diffusion is performed.

In an embodiment, double-sided phosphorus diffusion is performed on the silicon wafer on which step 2 is completed. The phosphorus diffusion method adopts high-temperature tubular phosphorus diffusion, and the phosphorus source is phosphorus oxychloride POCL₃. Alternatively, the phosphorus diffusion method adopts phosphorus ion implantation and oxidation annealing. The sheet resistance is 20 Ω /m to 80 Ω /m. In the diffusion process, a silicon oxide layer containing phosphorus is formed on a surface. The silicon oxide layer is commonly known as a PSG layer and has a thickness of 40 nm to 60 nm.

In an embodiment, phosphorus diffusion is performed on both surfaces of the silicon wafer. A conventional phosphorus-doped emitter is formed on a light-receiving surface and absorbs impurities. In subsequent texturing, the emitter is removed along with the absorbed impurities. In this step, the intrinsic amorphous silicon is converted to N-type doped polysilicon.

In step 4, an acid etching material is printed in an isolation groove.

In an embodiment, after the double-sided phosphorus expansion, PSG layers, that is, phosphorus-doped silicon dioxide layers, are formed on the front and back surfaces of the silicon wafer. The acid etching material is screen-printed with a width of 50 µm to 100 µm according to a pattern of the isolation groove. The etching material may etche and remove the PSG layer therein, exposing the underlying P-type silicon substrate.

In an embodiment, the acid etching material includes oxalic acid, surfactant, thickener, modified silicon dioxide, deionized water and sodium fluoride, and etches away the PSG layers at room temperature or with heating. The composition contents are as follows: oxalic acid 5wt%-20wt%, surfactant 5wt%-10wt%, thickener 10wt%-20wt%, modified silicon dioxide 20wt%-40wt%, deionized water 5wt%-20wt%, and sodium fluoride 1wt%-10wt%. After the etching material is printed, the residual etching material is cleaned off. The PSG layer which is not printed with the acid etching material on the back surface still remains and serves as an alkali barrier layer in a polishing process in step 5 to protect underlying N-type doped polysilicon. The PSG layer serves as an auxiliary product in the phosphorus diffusion process to block alkali etching, eliminating the need for separately depositing a silicon oxide layer or a silicon nitride layer as a barrier layer for alkali etching, thereby reducing process steps and cost.

In step 5, the isolation groove on the back surface is polished.

In an embodiment, the silicon wafer with acid etching material cleaned off is polished. That is, the polishing process is performed using a solution including 5% to 20% potassium hydroxide, sodium hydroxide, and TMAH, with an additive. The additive protects the oxide layer to ensure that a PSG layer is not etched excessively, leaving a residual thickness of the PSG layer of 30 nm to 50 nm. A polished flat structure is formed in a region not covered and protected by the PSG layer. That is, a patterned isolation groove on the back surface has a polished structure and a depth of 5 µm to 10 µm. The light-receiving surface of the silicon wafer is protected by a PSG layer and is not polished.

In step 6, the back surface is implanted with phosphorus ions, cleaned and oxidizing annealed.

Phosphorus ions are implanted on the back surface through an ion implantation process, and an implantation concentration is 0.1 to 1 times of a doping concentration for a silicon substrate. Since an isolation groove is not protected by the PSG layer, phosphorus ions are directly implanted, with a depth of 10 nm to 20 nm, into the bottom and sidewalls of the isolation groove of the P-type silicon substrate. A region other than the isolation groove is protected by the PSG layer, and the phosphorus ions implanted only exist on the PSG layer on the surface and are not implanted into the N-type polysilicon layer beneath the PSG layer. The PSG layers on the light-receiving surface and the back surface are cleaned and removed through HF acid, and oxidation annealing at 850°C is performed to promote and activate phosphorus on the sidewalls of the isolation groove, thereby performing doping. In the oxidation annealing process, a thermal oxide layer having a thickness of 20 nm to 50 nm is formed on the back surface.

In step 7, texturing is performed on the light-receiving surface.

In an embodiment, a warp-around silicon oxide layer on the front surface of the silicon wafer after step 6 is removed using a chain-type HF, and texturing is performed, that is, in a solution containing 5% to 20% potassium hydroxide, sodium hydroxide and TMAH, with a texturing additive as well as an additive for protecting the oxide layer. That is, the entire light-receiving surface is textured to form a pyramidal texture to trap light. The back surface is protected by a oxide layer from texturing. The oxide layer on the back surface after texturing has a residual thickness of 15 nm to 45 nm.

In step 8, an acid etching material is printed on the P-type silicon substrate.

In an embodiment, an acid etching material is screen-printed with a width of 200 µm to 300 µm on the silicon wafer, on which step 7 is completed, according to a pattern of a P-type interdigitated region on the silicon substrate. The etching material may etch away the thermal oxide layer therein, exposing the underlying N-type doped polysilicon layer.

In step 9, a second texturing is performed.

In an embodiment, a second texturing is performed on the silicon wafer for which step 8 is completed to: remove the polysilicon layer exposed on the back surface of the P-type silicon substrate after being processed through step 8; and perform a second texturing on the texture on the light-receiving surface to form finer microstructures for enhanced light trapping. To remove only the polysilicon layer exposed on the back surface without damaging the polished surface structure of the P-type silicon substrate, for the second texturing, the polysilicon layer is removed within a short period of time by using the conventional texturing bath formula, and the texturing time is 0.1 to 0.2 times of the conventional texturing time. Additionally, a tunneling oxide layer is arranged beneath the polysilicon layer, and the polished surface of the P-type interdigitated region is further protected from texturing.

In step 10, wet cleaning is performed.

In an embodiment, the tunneling oxide layer exposed in step 9 and the thermal silicon oxide layer in other regions are removed.

In step 11, stacked passivation is performed on the light-receiving surface and the back surface.

In an embodiment, a hydrogen-including dielectric layer is deposited on both the light-receiving and back surfaces to achieve chemical passivation of the back surface. In an embodiment, the back surface is deposited with a passivation stack of aluminum oxide and silicon nitride. The aluminum oxide is deposited through PECVD, ALD, or PEALD, with a thickness of 2 nm to 20 nm. The silicon nitride is deposited through PECVD, ALD, or PEALD, with a thickness of 60 nm to 200 nm. The light-receiving surface is deposited with a stack of aluminum oxide, silicon nitride, and silicon oxide films. The aluminum oxide film is deposited through PECVD, ALD, or PEALD with thicknesses of 2 nm to 20 nm, 50 nm to 80 nm, or 5 nm to 20nm, respectively.

In step 12, metallization is performed on the back surface.

In an embodiment, a P-type interdigitated region is partially opened using a laser beam or an acid etching material. The pattern of the opening includes dots, spaced-apart dots, lines, spaced-apart lines, or spaced-apart dots and lines. The diameter or width of the opening is 10 µm to 50 µm. Only the dielectric layer in the opening region is removed, without damaging the underlying P-type polysilicon layer. A low-etching silver paste or silver-aluminum paste is printed with a width of 50 µm to 100 µm over the opening region of the P-type interdigitated region, forming electrical contact with P-type polysilicon. An etching silver paste is printed over the N-type polysilicon. The glass component in the etching silver paste may etch through the dielectric layer so that silver is in contact with the N-type polysilicon. Co-firing is performed at 600°C to 800°C to form an electrode.

According to the embodiments, an isolation structure is arranged on a P-type back contact solar cell of the present disclosure. Specifically, in comparison to the related art, a vertical recess structure with a certain depth and width is arranged at the junction between a P-type silicon substrate and an N-type emitter. In addition, two vertical sidewalls and a bottom of the recess structure are doped with phosphorus atoms with a polarity opposite to that of a silicon substrate. A concentration of the phosphorus atoms is 0.1 to 1 times of a doping concentration for the silicon substrate. Counter-doping with the concentration may increase the sheet resistance of the region, potentially becoming an intrinsic silicon substrate. Thus, the conductivity is greatly reduced. In addition, a second texturing is performed on the light-receiving surface, enhancing anti-reflection (light trapping).

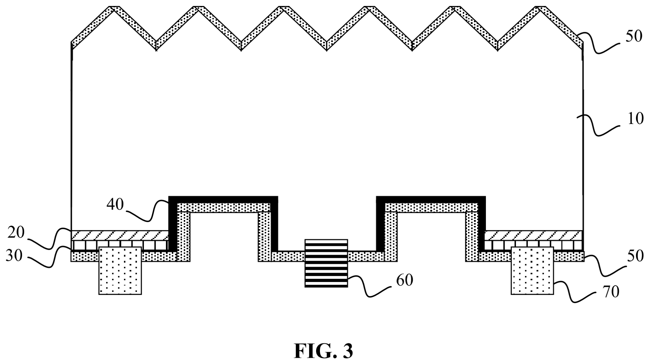

An interdigitated back contact solar cell is further provided according to the present disclosure. The interdigitated back contact solar cell includes a P-type silicon substrate 10. FIG. 3 is a schematic structural diagram according to an embodiment. As shown in FIG. 3, a back surface of the P-type silicon substrate 10 includes a P-type interdigitated region, an N-type interdigitated region, and an isolation groove.

The isolation groove is configured to isolate the P-type interdigitated region from the N-type interdigitated region.

The N-type interdigitated region includes a tunneling layer 20 and an N-type polysilicon layer 30 from inside to outside.

A sidewall and a bottom surface of the isolation groove are arranged with a phosphorus-doped neutral layer 40.

An outermost side of a light-receiving surface and an outermost side of the back surface of the P-type silicon substrate 10 include a passivation layer 50.

An N-type electrode 70 of the interdigitated back contact solar cell is arranged in the N-type interdigitated region. The N-type electrode 70 is configured to penetrate through the passivation layer 50 to contact with the N-type polysilicon layer 30.

A P-type electrode 60 of the interdigitated back contact solar cell is arranged in the P-type interdigitated region. The P-type electrode 60 is configured to penetrate through the passivation layer to contact with the P-type silicon substrate 10.

The solar cell shown in FIG. 3 includes the P-type silicon substrate 10, the tunneling layer 20, the N-type polysilicon layer 30, the phosphorus-doped neutral layer 40, the passivation layer 50, the P-type electrode 60, and the N-type electrode 70.

In an embodiment, the phosphorus-doped neutral layer 40 refers to a layer having extremely few carriers obtained through phosphorus doping on the side wall and the bottom surface of the isolation groove. The P-type electrode 60 refers to an electrode corresponding to the P-type interdigitated region. The N-type electrode 70 refers to an electrode corresponding to the N-type interdigitated region. The passivation layer 50 refers to a layer generated through a stacked passivation process and may be a stacked composite layer.

The interdigitated back contact solar cell provided according to the present disclosure includes the P-type silicon substrate 10. FIG. 3 is the schematic structural diagram of according to an embodiment. As shown in FIG. 3, a back surface of the P-type silicon substrate 10 includes a P-type interdigitated region, an N-type interdigitated region, and an isolation groove. The isolation groove is configured to isolate the P-type interdigitated region from the N-type interdigitated region. The N-type interdigitated region includes the tunneling layer 20 and the N-type polysilicon layer 30 from the inside to the outside. A side wall and a bottom surface of the isolation groove are arranged with the phosphorus-doped neutral layer 40. The outermost sides of a back surface and a light-receiving surface of the P-type silicon substrate 10 include the passivation layer 50. The N-type electrode 70 of the interdigitated back contact solar cell is arranged in the N-type interdigitated region and is configured to penetrate through the passivation layer 50 to contact with the N-type polysilicon layer 30. The P-type electrode 60 of the interdigitated back contact solar cell is arranged in the P-type interdigitated region and is configured to penetrate through the passivation layer 50 to contact with the P-type silicon substrate 10. In the isolation groove arranged between a P-type emitter (that is, P-type interdigitated region) and the N-type emitter (that is, N-type interdigitated region), phosphorus atoms with a polarity opposite to that of the P-type silicon substrate 10 are doped. Counter-doping with the concentration may increase the sheet resistance of the region, potentially becoming intrinsic silicon. Thus, the conductivity of the sidewalls and bottom surface of the isolation groove is greatly reduced, significantly reducing the carrier concentration in the region. In this way, electrical isolation between interdigitated regions is enhanced, thereby reducing the internal loss of a battery and improving the photoelectric conversion efficiency of the battery.

The above embodiments are described in a progressive manner. Each of the embodiments is mainly focused on describing its differences from other embodiments, and reference may be made among these embodiments with respect to the same or similar parts. Since apparatuses disclosed in embodiments correspond to the method disclosed in the embodiments, the description of the apparatuses is simple, and reference may be made to the relevant part of the methods.

It should also be noted that in the present specification, relational terms such as first, second, etc., are merely used to distinguish an entity or operation from another entity or operation, and it is not necessarily required or implicated that any such actual relationship or order is present between these entities or operations. In addition, the term "include", "comprise" or any other variation thereof is intended to encompass a nonexclusive inclusion, so that a process, method, article, or device that includes a series of elements includes not only those elements but also other elements not explicitly listed, or elements that are inherent to such a process, method, article, or device. Unless expressively limited, the statement "including a..." does not exclude the case that other similar elements may exist in the process, method, article or device including the series of elements.

## Claims

1. A method for manufacturing an interdigitated back contact solar cell, comprising:
sequentially arranging a tunneling layer and an N-type polysilicon layer on a back surface of a P-type silicon substrate to obtain a base silicon wafer;
etching a predetermined isolation region on a back surface of the base silicon wafer to obtain an isolation groove which is patterned, wherein the isolation groove isolates a P-type interdigitated region from an N-type interdigitated region;
performing phosphorus doping on a sidewall and a bottom surface of the isolation groove;
removing the N-type polysilicon layer and the tunneling layer which are phosphorus-doped and arranged within the P-type interdigitated region to obtain a photovoltaic precursor; and
performing stacked passivation and metallization on a surface of the photovoltaic precursor to obtain an interdigitated back contact solar cell.

2. The method according to claim 1, wherein the sequentially arranging a tunneling layer and an N-type polysilicon layer on a back surface of a P-type silicon substrate to obtain a base silicon wafer comprises:
arranging a tunneling layer on the back surface of the P-type silicon substrate;
arranging an intrinsic amorphous silicon layer on a surface of the tunneling layer; and
performing phosphorus diffusion on the P-type silicon substrate arranged with the intrinsic amorphous silicon layer, such that the intrinsic amorphous silicon layer is converted into an N-type polysilicon layer to obtain the base silicon wafer, and generating, on a surface of the base silicon wafer, a PSG layer to be removed.

3. The method according to claim 2, wherein the performing phosphorus diffusion on the P-type silicon substrate arranged with the intrinsic amorphous silicon layer comprises:
performing double-sided phosphorus diffusion on the P-type silicon substrate arranged with the intrinsic amorphous silicon layer to generate, on both surfaces of the base silicon wafer, the PSG layer to be removed.

4. The method according to claim 1, wherein before the performing phosphorus doping on a sidewall and a bottom surface of the isolation groove, the method further comprises:
performing alkali polishing on the isolation groove.

5. The method according to claim 1, wherein the performing phosphorus doping on a sidewall and a bottom surface of the isolation groove comprises:
performing phosphorus ion implantation on a surface of the base silicon wafer and removing the PSG layer; and
annealing the base silicon wafer for which the PSG layer is removed, to complete phosphorus doping, and forming, on the surface of the base silicon wafer, a thermal silicon oxide layer to be removed.

6. The method according to claim 1, wherein before the removing the N-type polysilicon layer and the tunneling layer which are phosphorus-doped and arranged within a P-type interdigitated region to obtain a photovoltaic precursor, the method further comprises:
performing a first texturing on a light-receiving surface of the base silicon wafer, wherein both the light-receiving surface and the back surface of the base silicon wafer are in contact with a solution for the first texturing.

7. The method according to claim 1, wherein the removing the N-type polysilicon layer and the tunneling layer which are phosphorus-doped and arranged within a P-type interdigitated region to obtain a photovoltaic precursor comprises:
performing acid etching on the P-type interdigitated region to remove a thermal silicon oxide layer in the P-type interdigitated region; and
removing the N-type polysilicon layer in the P-type interdigitated region, and performing wet cleaning to remove the thermal silicon oxide layer and the tunneling layer on the back surface of the base silicon wafer, to obtain the photovoltaic precursor.

8. The method according to claim 7, wherein the removing the N-type polysilicon layer in the P-type interdigitated region comprises:
performing a second texturing on a light-receiving surface of the base silicon wafer and removing the N-type polysilicon layer in the P-type interdigitated region through a solution for the second texturing.

9. The method according to any one of claims 1 to 8, wherein before the sequentially arranging a tunneling layer and an N-type polysilicon layer on a back surface of a P-type silicon substrate, the method further comprises:
performing double-sided polishing on the P-type silicon substrate.

10. An interdigitated back contact solar cell, comprising a P-type silicon substrate, wherein a back surface of the P-type silicon substrate comprises a P-type interdigitated region, an N-type interdigitated region, and an isolation groove;
the isolation groove is configured to isolate the P-type interdigitated region from the N-type interdigitated region;
the N-type interdigitated region comprises a tunneling layer and an N-type polysilicon layer from inside to outside;
a sidewall and a bottom surface of the isolation groove are arranged with a phosphorus-doped neutral layer;
an outermost side of a light-receiving surface and an outermost side of the back surface of the P-type silicon substrate comprise a passivation layer;
an N-type electrode of the interdigitated back contact solar cell is arranged in the N-type interdigitated region, wherein the N-type electrode is configured to penetrate through the passivation layer to contact with the N-type polysilicon layer;
a P-type electrode of the interdigitated back contact solar cell is arranged in the P-type interdigitated region, wherein the P-type electrode is configured to penetrate through the passivation layer to contact with the P-type silicon substrate.
